# EUROPEAN PATENT APPLICATION

(11) **EP 1 482 360 A1**
(43) Date of publication of application: **01.12.2004**
(21) Application number: 03707016.6
(22) Date of filing: 24.02.2003
(51) Int. Cl.: G03F 7/022, G03F 7/004, H01L 21/027

(54) **PHOTOSENSITIVE RESIN COMPOSITION**

(30) Priority: 27.02.2002 JP 2002051487
(71) Applicant: CLARIANT INTERNATIONAL LTD., 4132 Muttenz (CH)
(72) Inventor: TAKAHASHI, Shuichi, Clariant(Japan)K.K., Daitocho, Ogasa-gun, Shizuoka 437-1496 (JP); KAWATO, Shunji, Clariant(Japan)K.K., Shizuoka 437-1496 (JP)
(74) Representative: Hütter, Klaus, Dr.
(86) International application number: PCT/JP2003/001987
(87) International publication number: WO 2003/073167

(57) **Abstract**

A photosensitive resin composition comprises an alkali soluble acrylic resin, a photosensitizer containing a quinone diazide group, a solvent and if necessary a hardening agent containing epoxy groups, wherein said solvent is a mixture of propylene glycol monomethyl ether acetate and a solvent having smaller vapor pressure than that of propylene glycol monomethyl ether acetate at the normal temperature and the atmospheric pressure and said composition further contains a phenolic compound represented by general formula (I) below. The photosensitive resin composition can be used suitably as a material for forming an interlayer dielectric or a planarization film, etc. of semiconductor devices, flat panel displays or the like. 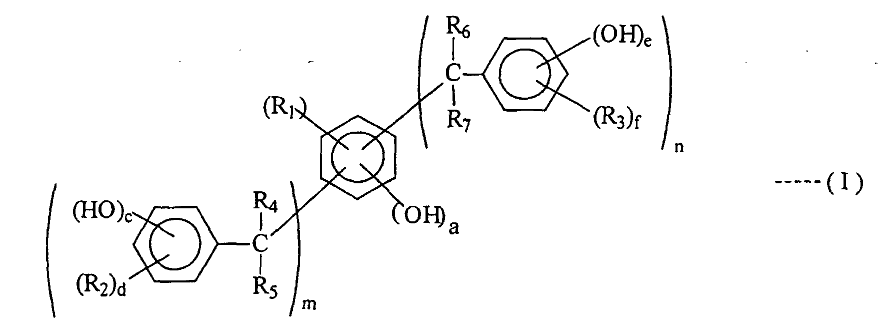 wherein R₁, R₂, R₃, R₄, R₅, R₆ and R₇ represent independently H, a C₁₋₄ alkyl group or 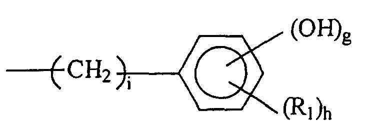 whereupon each of m and n is independently an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

## Description

### Technical field of the invention

The present invention relates to a photosensitive resin composition, further in detail to the photosensitive resin composition which is suitable for formation of an interlayer dielectric or a planarization film for a semiconductor device, a flat panel display (FPD), and so on.

### Background art

In the wide fields of manufacturing of a semiconductor integrated circuits such as LSI or a display face of FPD, manufacturing of a circuit substrate for a thermal head and so on, photolithography technique has so far been employed for forming microelements or conducting fine processing. In the photolithography technique, a positive- or negative-working photosensitive resin composition is used for forming a resist pattern. In the recent years, a formation technique of an interlayer dielectric or a planarization film, which insulates between wiring circuits in a semiconductor integrated circuit or an FPD, is being paid attention as new applications. Particularly a market requirement for a highly precise and fine technology is strong and then it is said that a planarization film which is highly transparent and excellent in dielectric property is an essential material in order to attain such highly precise and fine technology. Many studies are being conducted for the photosensitive resin composition used for such applications and many patents are filed and made laid-open, for example Japanese Patent Publication Laid-open No. Hei7-248629, and Japanese Patent Publication Laid-open No. Hei8-262709. However the materials which were developed as being suitable for these interlayer dielectric and planarization film have less stability depending on time. Therefore a special care is required for a storage circumstance of the composition compared with a positive-working resist which is used for a fine processing commonly. Further when these compositions are used for formation of an FPD display face or manufacturing of a semiconductor device, it is known that a coating property of the photosensitive resin composition affects a display performance such as light unevenness of the FPD at the time of turning on light of the panel. Furthermore a development residue often causes a defect of hole of the pattern, and connecting failure of wires are taken place by this and would become a cause of prevention of electricity conduction of metals. Because of this, a photosensitive resin composition, by which a pattern not only having a excellent dielectric property, a high heat resistance and a good stability depending on time but also having an improved coating property and no development residue can be formed, is being required.

In order to respond this matter, the inventors of the present invention proposed, in Japanese Patent Application No. 2001-389601, the photosensitive resin composition by which a thin film having a good insulating property, heat-resistance, resolution and light transmission property can be formed, and whose stability depending on time is good even if a hardening agent is added. In addition, heat-resistance of the film formed by using the photosensitive resin composition is further improved. The photosensitive resin composition of Japanese Patent Application No. 2001-389601 is a photosensitive resin composition comprising an alkali-soluble acrylic resin, a photosensitizer containing a quinone diazide group, a phenolic compound represented by the general formula (I) described later, and if necessary a hardening agent having epoxy groups. However development residue or a coating property of the photosensitive resin composition is not satisfactory. Therefore the problems still remain.

Referring to the situation described above, the objects of the present invention are to offer the photosensitive resin composition without the problems described above.

It means that the object of the present invention is to offer a photosensitive resin composition having a good stability depending on time, an excellent insulation property, heat-resistance, and transparent property as well as a good coating property and no development residue, which can be preferably used for an interlayer dielectric or a planarization film for an FPD's display face or a semiconductor device, and so on.

Further the object of the present invention is to offer a photosensitive resin composition comprising an alkali-soluble acrylic resin, a photosensitizer containing a quinone diazide group, a phenolic compound represented by the general formula (I) described later and if necessary a hardening agent having epoxy groups, by which a pattern having a good coating property but no development residue can be formed.

### Disclosure of the Invention

As a result of eager study and examination, the present inventors found that the above described objects can be attained by using some particular solvents as a solvent in a photosensitive resin composition comprising an alkali-soluble acrylic resin, a photosensitizer containing a quinone diazide group, a phenolic compound represented by the general formula (I) described later, a solvent and if necessary a hardening agent having epoxy groups, and reached to the present invention.

It means that the present invention relates to a photosensitive resin composition which is characterized by comprising an acrylic resin as an alkali-soluble resin, a mixture of propylene glycol monomethyl ether acetate and a solvent having smaller vapor pressure than that of propylene glycol monomethyl ether acetate at the normal temperature and the atmospheric pressure as a solvent, and besides a phenolic compound represented by the general formula (I) described below in the photosensitive resin composition comprising an alkali-soluble resin, a photosensitizer containing a quinone diazide group, a solvent, and if necessary a hardening agent having epoxy groups. 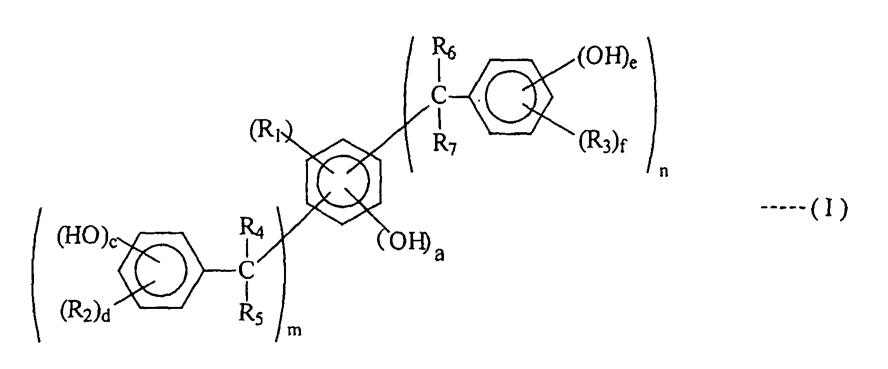 wherein R₁, R₂, R₃, R₄, R₅, R₆ and R₇ independently represent H, a C₁-C₄ alkyl group or a group represented by the formula: 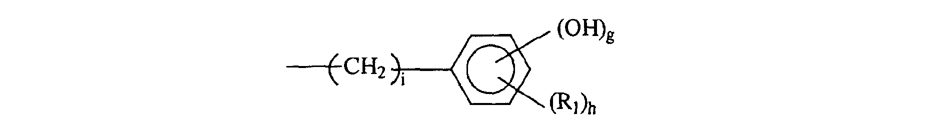 whereupon each of m and n is independently an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

As described above, the photosensitive resin composition of the present invention comprises an alkali-soluble resin, a photosensitizer containing a quinone diazide group, a phenolic compound represented by the general formula (I) described above, a solvent and if necessary a hardening agent containing epoxy groups. Since the solvent to be used takes a large characteristic in the present invention, the constitutional compositions of the photosensitive resin composition of the present invention are now be explained in detail from the solvent in order.

The solvent to be used in a photosensitive resin composition of the present invention needs to be a mixture of propylene glycol monomethyl ether acetate and a solvent having smaller vapor pressure than that of propylene glycol monomethyl ether acetate at the normal temperature and the atmospheric pressure. The vapor pressure of propylene glycol monomethyl ether acetate at the normal temperature (20°C) and under the atmospheric pressure (1013 hPa) is 3.5 mmHg. Solvents, the vapor pressure of which at the normal temperature and the atmospheric pressure is lower than that of propylene glycol monomethyl ether acetate, can be exemplified by dipropylene glycol n-butyl ether (0.06 mmHg), tripropylene glycol methyl ether (0.02 mmHg), propylene glycol phenyl ether (0.01 mmHg), propylene glycol n-butyl ether (0.6 mmHg), 2-heptanone (2.1 mmHg), methyl-3-methoxy propionate (1.8 mmHg), methyl 2-hydroxy propionate (0.3 mmHg), ethyl 2-hydroxy propionate (2.7 mmHg), butyl 2-hydroxy propionate (0.03 mmHg), ethylene glycol monoethyl ether acetate (1.1 mmHg), propylene glycol (0.08 mmHg), ethyl 3-ethoxy propionate (0.7 mmHg) , and so on. These solvents can be used singly with propylene glycol monomethyl ether acetate in a mixture or as a mixture of two or more kinds thereof with propylene glycol monomethyl ether acetate in a mixture.

In the present invention, solvents so far being used as a solvent for a photosensitive resin composition may be further used with the solvent above such as propylene glycol monoalkyl ethers, e.g. propylene glycol monomethyl ether and propylene glycol monoethyl ether; propylene glycol monoalkyl ether acetates, e.g. propylene glycol monomethyl ether acetate and propylene glycol monoethyl ether acetate; aromatic hydrocarbons, e.g. toluene and xylene; ketones, e.g. methyl ethyl ketone, 2-heptanone, and cyclohexanone; amides, e.g. N,N-dimethylacetamide and N-methylpyrrolidone; lactones, e.g. γ-butyrolactone; and so on. Those solvents can used in a mixture as far as the objects of the present invention cannot be spoiled.

As a solvent having smaller vapor pressure at the normal temperature and the atmospheric pressure than that of propylene glycol monomethyl ether acetate to be used in a mixture with propylene glycol monomethyl ether acetate, ethyl 2-hydroxypropionate, propylene glycol n-butyl ether, propylene glycol are preferable, and ethyl 2-hydroxypropionate is more preferable. A preferable mixing range of propylene glycol monomethyl ether acetate and the solvent, the vapor pressure of which at the normal temperature and the atmospheric pressure is lower than that of propylene glycol monomethyl ether acetate, is preferably 95:5 to 50:50, more preferably 90:10 to 70:30.

In this connection the vapor pressure data of solvents can be referred to "Solvent Hand Book" published by Kodansya, "14102 Chemical Products" published by Kagaku Kogyo Nippoh Co., "MSDS data (Material Safety data Sheet)" provided by solvent manufacturers and so on.

As the alkali-soluble resin used in the photosensitive resin composition of the present invention, acrylic resins are preferable. As the acrylic resins, alkali-soluble polyacrylic esters(a), alkali-soluble polymethacrylic esters (b), and alkali-soluble poly(acrylic ester-co-methacrylic ester) containing at least one kind of acrylic esters and at least one kind of methacrylic esters as a constitutional unit (c) can be exemplified. These acrylic resins can be used singly or in a mixture of two or more kinds thereof. As these acrylic resins, acrylic resins containing an organic acid monomer as a comonomer is preferred in order to make the resin alkali-soluble, however a comonomer unit to give alkali-solubility to the resin is not limited in the organic acid monomer.

As a monomer component which constitutes these polyacrylic esters, polymethacrylic esters, and poly(acrylic ester-co-methacrylic ester), an acrylic ester, a methacrylic ester, an organic acid monomer and other copolymerizable monomers are raised.

As these monomer components which constitutes these polyacrylic esters, acrylic esters, methacrylic esters and organic acid monomers, ones illustrated below are preferred.

### Acrylic ester:

Methyl acrylate, ethyl acrylate, n-propyl acrylate, n-butyl acrylate, n-hexyl acrylate, isopropyl acrylate, isobutyl acrylate, t-butyl acrylate, cyclohexyl acrylate, benzyl acrylate, 2-chloroethyl acrylate, methyl-α-chloroacrylate, phenyl-α-bromoacrylate and so on.

### Methacrylic ester:

Methyl methacrylate, ethyl methacrylate, n-propyl methacrylate, n-butyl methacrylate, n-hexyl methacrylate, isopropyl methacrylate, isobutyl methacrylate, t-butyl methacrylate, cyclohexyl methacrylate, benzyl methacrylate, phenyl methacrylate, 1-phenylethyl methacrylate, 2-phenylethyl methacrylate, furfuryl methacrylate, diphenylmethyl methacrylate, pentachlorophenyl methacrylate, naphthyl methacrylate, iso-boronyl methacrylate, hydroxyethyl methacrylate, hydroxypropyl methacrylate, and so on.

### Organic acid monomer:

Unsaturated monocarboxylic acids such as acrylic acid, methacrylic acid, and crotonic acid; unsaturated dicarboxylic acids and their anhydride such as itaconic acid, maleic acid, fumaric acid, citraconic acid, and metaconic acid; 2-acryloyl hydrogenphthalate, 2-acryloyloxypropyl hydrogenphthalate, and so on.

Other copolymerizable monomers can be exemplified with maleic diesters, fumaric diesters, styrene and styrene derivatives, acrylonitrile, (meth)acrylamide, vinyl acetate, vinyl chloride, vinylidene chloride, and so on. These other copolymerizable monomers may be used if necessary and its quantity shall be the quantity in the limit wherein the acrylic resins can attain the objects of the present invention.

A preferable acrylic resin of the present invention is a copolymer containing a constitutional unit derived from alkyl (meth)acrylate and a constitutional unit derived from (meth)acrylic acid, and more preferable one is the copolymer containing 5 to 30 mole-% of (meth) acrylic acid. A preferable limit of weight average molecular weight as determined by polystyrene standards of acrylic resins of the present invention is 20,000 to 40,000, more preferably 25,000 to 30,000.

A photosensitizer having a quinone diazide group which is used in the photosensitive resin composition of the present invention may be any one if it is a photosensitizer having a quinone diazide group. Of the photosensitizers, it is preferred that the one which is obtained by reacting a quinone diazide sulfonic halide such as a naphthoquinone diazide sulfonic chloride or a benzoquinone diazide sulfonic chloride with a low or high molecular compound having a functional group which is condensable with this acid halide. The functional group which is condensable with acid halide here includes a hydroxyl group, an amino group, and so on and particularly a hydroxyl group is preferable. A low molecular compound containing a hydroxyl group includes the phenolic compound represented by the general formula (I) described above. These photosensitizers having a quinone diazide group are used usually at 1 to 30 parts by weight relative to 100 parts by weight of a resin component in a photosensitive resin composition of the present invention.

The photosensitive resin composition of the present invention further contains preferably the phenolic compound represented by the above-described general formula (I). As the low molecular compound having a phenolic hydroxyl group represented by the above-described general formula (I) is low molecular, it is used favorably and suitably in the photosensitive resin composition of the present invention for controlling a dissolution rate as a dissolution promoter or for controlling or improving a sensitivity of a photosensitive resin composition. The controlling of the dissolution rate or the sensitivity can be made by controlling an amount of these phenolic compounds added. When improving a dissolution rate or a sensitivity, the quantity of the phenolic compound added may be increased and when decreasing the dissolution rate or sensitivity, the quantity may be decreased. As these amounts can be different depending on a resin to be used or the molecular weight thereof, the amount of these phenolic compounds added may be chosen an adequate amount according to a resin to be used or the molecular weight thereof. Furthermore by using these phenolic compounds, a low molecular compound is contained, as a result, in a resin component to be dissolution-inhibited by an azo coupling reaction with a photosensitizer compared with not using them. Thereby the difference of a dissolution rate between an exposed area and an unexposed area, i.e. contrast can be made larger to enable to improve a resolution of the photosensitive resin composition.

The low molecular compound having a phenolic hydroxyl group represented by the above described general formula (I) includes o-cresol, m-cresol, p-cresol, 2,4-xylenol, 2,5-xylenol, 2, 6-xylenol, bisphenol A, B, C, E, F or G, 4,4',4''-methylidyne trisphenol, 2,6-bis[(2-hydroxy-5-methylphenyl)methyl]-4-methylphenol, 4,4'-[1-[4-[1-(4-hydroxyphenyl)-1-methylethyl]phenyl]-ethylidene]bisphenol, 4,4'-[1-[4-[2-(4-hydroxyphenyl)-2-propyl]phenyl]ethylidene]bisphenol, 4,4',4''-ethylidyne trisphenol, 4-[bis(4-hydroxyphenyl)methyl]-2-ethoxyphenol, 4,4'-[(2-hydroxyphenyl)methylene]-bis[2,3-dimethylphenol], 4,4'-[(3-hydroxyphenyl) methylene]bis[2,6-dimethylphenol], 4,4'-[(4-hydroxyphenyl)methylene]bis[2,6-dimethylphenol], 2,2'-[(2-hydroxyphenyl)methylene]bis[3,5-dimethylphenol], 2,2'-[(4-hydroxyphenyl)methylene]bis[3,5-dimethylphenol], 4,4'-[(3,4-dihydroxyphenyl)methylene]bis[2,3,6-trimethyl phenol], 4-[bis(3-cyclohexyl-4-hydroxy-6-methylphenyl)methyl]-1,2-benzenediol, 4,6-bis[(3,5-dimethyl-4-hydroxyphenyl)methyl]-1,2,3-benzenetriol, 4,4'-[(2-hydroxyphenyl)methylene]bis[3-methylphenol], 4,4',4''-(3-methyl-1-propanyl-3-ylydine)trisphenol, 4,4',4'',4'''-(1,4-phenylenedimethylidine)tetrakisphenol, 2,4,6-tris[(3,5-dimethyl-4-hydroxyphenyl)methyl]-1,3-benzenediol, 2,4,6-tris[(3,5-dimethyl-2-hydroxyphenyl)methyl]-1,3-benzenediol, 4,4'-[1-[4-[1-[4-hydoxy-3,5-bis[(hydroxy-3-methylphenyl)methyl]phenyl]-1-methylethyl]phenyl]-ethylidene]bis[2,6-bis(hydroxy-3-methylphenyl) methyl]phenol, 4,4'-methylenebis[2-[(2-hydroxy-5-methylphenyl)methyl]-6-methylphenol], and so on. The preferable compounds include 4,4',4''-methylidine trisphenol, 2,6-bis[(2-hydroxy-5-methylphenyl)methyl]-4-methylphenol, 4,4'-[1-[4-[1-(4-hydroxyphenyl)-1-methylethyl]phenyl]ethylidene]-bisphenol, 4,4'-[1-[4-[2-(4-hydroxyphenyl)-2-propyl]phenyl]ethylidene]-bisphenol, 4,4',4''-ethylidine trisphenol, 4,4'-methylenebis[2-[(2-hydroxy-5-methylphenyl)methyl]-6-methylphenol], and so on.

Among these low molecular compounds having a phenolic hydroxyl group, compounds represented by the formula (II) or (III) described below are preferable.

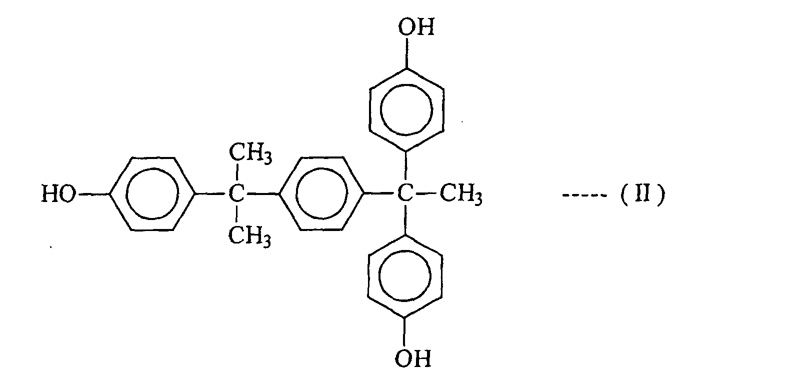

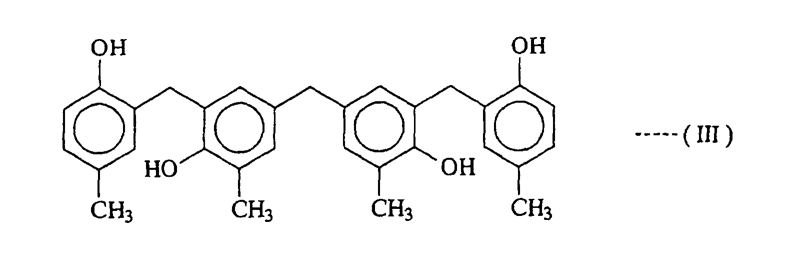

These low molecular compounds having a phenolic hydroxyl group are used at the dosage of 1 to 20 parts by weight relative to 100 parts by weight of an alkali-soluble resin.

Further in a photosensitive resin composition of the present invention, a hardening agent having epoxy groups can be incorporated. This hardening agent having epoxy groups includes a bisphenol A type epoxy resin, a bisphenol F type epoxy resin, a phenol novolak type epoxy resin, a cresol novolak type epoxy resin, an alicyclic epoxy resin, glycidyl ester type epoxy resin, a glycidyl amine type epoxy resin, and a heterocyclic epoxy resin. Not only above described high molecular type epoxy resin, but also a diglycidyl ether of bisphenol A or bisphenol F and so on, which are a low molecular type epoxy compound, can be used as a hardening agent in the present invention. This hardening agent having epoxy groups is used 0. 5 to 10 parts by weight, preferably 1 to 7 parts by weight relative to 100 parts by weight of alkali-soluble resin.

In the photosensitive resin composition of the present invention, there may be incorporated, if necessary, adhesion aids, surfactants, and so on. Examples of the adhesion aids include alkylimidazolines, butyric acid, alkyl acids, polyhydroxystyrene, polyvinyl methyl ether, t-butylnovolak, epoxysilane, epoxy polymers, silanes, and so on. Further, examples of the surfactants include nonionic surfactants such as polyglycols and the derivatives thereof, i.e., polypropylene glycol or polyoxyethylene lauryl ether, and so on; fluorine-containing surfactants such as Fluorad (trade name; product of Sumitomo 3M Co., Ltd.), Megafac (trade name; product of Dai-Nippon Ink & Chemicals, Inc.), Surflon (trade name; product of Asahi Glass Company, Ltd.) and organosiloxane surfactants such as KP341 (trade name; product of Shin-Etsu Chemical Co., Ltd.).

The photosensitive resin composition of the present invention is prepared by dissolving the above described components at the determined dosage in a solvent. At this time each component may be dissolved in advance respectively in a solvent and each dissolved component may be mixed and prepared at the determined ratio right before usage. Usually the solution of a photosensitive resin composition is provided for its use after filtered with 0.2 µm filter, and so on.

The photosensitive resin composition of the present invention is formed to a thin film by the following way, for example and is utilized as a planarization film or an interlayer dielectric. It means that first the solution of the photosensitive resin composition of the present invention is applied on a substrate, whereupon a circuit pattern or a semiconductor device, and so on are formed, if necessary and a pre-bake of the substrate is conducted to form a coated film of the photosensitive resin composition. Next, this substrate is pattern-wise exposed to light through a determined mask, developed by using an alkali developer, and rinsed if necessary to form a thin film positive pattern of the photosensitive resin composition.

In the above described formation of a thin film, as a coating method of the photosensitive resin composition solution, an optional method can be applied such as a spin coat method, a roll coat method, a land coat method, a spray coat method, a flow spreading coat method, a dip coat method, and so on. A radiation to be used for an exposure to light can include ultra violet light such as g-line, i-line, and so on, deep ultra violet light such as KrF eximer laser or ArF eximer laser, and so on, X-ray, electron beams, and so on, for example. Further a development method includes methods so far applied for a resist development such as a paddle development method, a dipping development method, and a swinging dip development method. A developer includes inorganic alkalis such as sodium hydroxide, potassium hydroxide, sodium carbonate, and sodium silicate, ammonia, organic amines such as ethylamine, propylamine, diethylamine, diethylamino ethanol, and triethylamine, organic tertiary amines such as tetramethylammonium hydroxide, and so on. And as a developer, organic tertiary amines are preferred.

### Best mode for practicing the Invention

The present invention will now be described more specifically by reference to Examples which, however, are not to be construed to limit the present invention in any way.

### Example 1

### <Preparation of Photosensitive Resin Composition>

100 parts by weight of poly(methyl methacrylate-co-2-hydroxypropyl methacrylate-co-methacrylic acid) [the containing ratio of methacrylic acid, 15 mole-%], the weight average molecular weight of which is 25,000 as determined by polystyrene standards, 22 parts by weight of the esterified product between the compound represented by the above-described formula (II) and 1,2-naphthoquinone diazide-5-sulfonyl chloride, 10 parts by weight of the phenolic compound represented by the above-described formula (II), and 3 parts by weight of bisphenol A type epoxy resin, Epicoat 828 (produced by Yuka-Shell Epoxy Company) were dissolved in a mixed solvent composed of propylene glycol monomethyl ether acetate and ethyl 2-hydroxypropionate (the mixing ratio is 75:25). Then 300 ppm of Megafac R-08 (produced by Dai-Nippon Chemicals & Inks Co., Inc.) was added to the solution in order to prevent a radial wrinkles which was so called "striation" and was formed in the surface of a resist film upon a rotational coating. After stirred the solution, the solution was filtrated with 0.2 µm filter to prepare a photosensitive resin composition of the present invention.

### <Formation of Thin Film Pattern>

The composition was applied on a 4-inch silicon wafer by a rotational coating and was baked on a hot plate at 100°C for 90 seconds to form a resist film of 3.0 µm in thickness. The resist film was exposed with light through a test pattern which contains line and space patterns having 1:1 line and space width with various kinds of line widths and contact hole patterns with a various kind of diameters at an optimal exposure dose by g + h-line stepper made by Nikon Co. (FX-604F), and was developed at 23°C for 60 seconds with 0.4 weight-% aqueous solution of tetramethylammonium hydroxide to form line and space patterns with 1:1 line and space width and contact hole patterns. Then the 4-inch silicon wafer on which patterns were formed was post-baked by heating at 220°C for 60 minutes in an oven.

### < Measurement of Limit of Resolution >

By the thin film pattern forming method described above, line and space patterns with a various widths were formed. Before post-bake treatment, the patterns were observed by Scanning Electronic Microscope (SEM), and a minimal line and space pattern width which was formed at the optimal light-exposure quantity of 5 µm line and space width was made a resolution.

### <Evaluation of Heat Resistance>

A form deterioration of a contact hole having 10 µm in diameter and hole diameter : hole gap being 1:1 before and after post-bake treatment which was made at 220°C for 60 minutes was observed by SEM. And the results were evaluated by the way that ○ was put when no flowing of a pattern was observed and × was put when flowing was observed. The result is shown in Table 1.

### <Evaluation of Transmittance>

After a coated film was formed by conducting the same operation as described above except using a quartz glass substrate instead of a 4-inch silicon wafer, a heat treatment was made at 220°C for 60 minutes to obtain a glass substrate having a thin film pattern. And then the transmittance of this glass substrate having a thin film pattern at 400 nm wavelength was measured using an ultra violet - visible light spectrophotometer, CARY4E (Ballian company). The results were evaluated by the way that ○ was put when a transmittance was 85% or higher and × was put when it was lower than 85%. The result is shown in Table 1.

### <Evaluation of Applicability>

A photosensitive resin composition was applied on a 360 x 465 mm size glass substrate with chromium film by a rotational coating followed by baking on a hot plate at 100°C for 90 seconds to obtain a resist film with 3 µm thickness. Film thickness distribution of this resist film was measured at 600 points and an evenness of applied film thickness was evaluated by using an index of standard deviation, σ. At this time ⓞ was put in the case that σ is less than 200 Å, ○ was put when σ was 200 to 300 Å and × was put when σ was greater than 300 Å. The result is shown in Table 1.

### <Evaluation of Development Residue>

A photosensitive resin composition was applied on a 360 x 465 mm size glass substrate with chromium film by a rotational coating followed by baking on a hot plate at 100°C for 90 seconds to obtain a resist film with 3 µm thickness. The resist film was exposed with light through a test pattern which contains line and space patterns having 1:1 line and space width with various kinds of line widths and contact hole patterns with various kinds of diameters at an optimal exposure dose by g + h-line stepper made by Nikon Co. (FX-604F), and was developed at 23°C for 60 seconds with 0.4 weight-% aqueous solution of tetramethylammonium hydroxide to form a hole pattern with 1:1 hole diameter and hole gap ratio with 10 µm diameter. This hole part was observed by SEM and an evaluation whether a residue after development remained or not was made. Whereupon, ⓞ was put when no development residue was observed, ○ was put when residue was observed on the area surrounding a pattern, upon a place and × was put when a plenty number of residues were observed on the area surrounding a pattern. The result is shown in Table 1.

### Example 2

The same manner was taken as Example 1 except for using the esterified product between the compound represented by the formula (III) described before and 1,2-naphthoquinone diazide-5-sulfonyl chloride instead of the esterified product between the compound represented by the formula (II) and 1,2-naphthoquinone diazide-5-sulfonyl chloride, and 10 parts by weight of the compound represented by the formula (III) described before instead of 10 parts by weight of the compound represented by the formula (II). The result in Table 1 was obtained.

### Example 3

The same manner was taken as Example 1 except for using a mixed solvent composed of propylene glycol monomethyl ether acetate and propylene glycol n-butyl ether (the mixing ratio is 75:25) instead of a mixed solvent composed of propylene glycol monomethyl ether acetate and ethyl 2-hydroxypropionate (the mixing ratio is 75:25) and the result in Table 1 was obtained.

### Example 4

The same manner was taken as Example 2 except for using a mixed solvent composed of propylene glycol monomethyl ether acetate and propylene glycol n-butyl ether (the mixing ratio is 75:25) instead of a mixed solvent composed of propylene glycol monomethyl ether acetate and ethyl 2-hydroxypropionate (the mixing ratio is 75:25) and the result in Table 1 was obtained.

### Example 5

The same manner was taken as Example 1 except for using a mixed solvent composed of propylene glycol monomethyl ether acetate and propylene glycol (a mixing ratio 75:25) instead of a mixed solvent composed of propylene glycol monomethyl ether acetate and ethyl 2-hydroxypropionate (the mixing ratio is 75:25) and the result in Table 1 was obtained.

### Example 6

The same manner was taken as Example 2 except for using a mixed solvent composed of propylene glycol monomethyl ether acetate and propylene glycol (the mixing ratio is 75:25) instead of a mixed solvent composed of propylene glycol monomethyl ether acetate and ethyl 2-hydroxypropionate (the mixing ratio is 75:25) and the result in Table 1 was obtained.

### Comparative Example 1

The same manner was taken as Example 1 except for using a solvent composed only of propylene glycol monomethyl ether acetate instead of a mixed solvent composed of propylene glycol monomethyl ether acetate and ethyl 2-hydroxypropionate (the mixing ratio is 75:25) and the result in Table 1 was obtained.

**Table 1**

| | Resolution (µm) | Heat-resistance | Trans-mittance | Applicability | Development Residue |
|---|---|---|---|---|---|
| Example 1 | 2.2 | ○ | ○ | ⓞ | ⓞ |
| Example 2 | 2.2 | ○ | ○ | ⓞ | ⓞ |
| Example 3 | 2.2 | ○ | ○ | ○ | ○ |
| Example 4 | 2.2 | ○ | ○ | ○ | ○ |
| Example 5 | 2.2 | ○ | ○ | ○ | ○ |
| Example 6 | 2.2 | ○ | ○ | ○ | ○ |
| Comparative Example 1 | 2.3 | ○ | ○ | × | × |

From the Table 1 above, it can be known that the applicability and development residue of the photosensitive resin composition of the present invention are improved keeping its resolution, heat-resistance and light transmittance in a good state by using a mixture of propylene glycol monomethyl ether acetate and a solvent having smaller vapor pressure at the normal temperature and the atmospheric pressure than that of propylene glycol monomethyl ether acetate instead of using propylene glycol monomethyl ether acetate alone as a solvent in the photosensitive resin composition comprising an alkali-soluble resin which is an acrylic resin, a photosensitizer containing a quinone diazide group, a phenolic compound represented by the general formula (I) described above, a solvent and if necessary a hardening agent. In this connection stability depending on time of the photosensitive resin composition was good in any cases.

### Advantageous effects of the Invention

As explained above, by the present invention, a photosensitive resin composition can be obtained with good stability depending on time, high resolution, high heat-resistance and good light transmittance of the pattern film formed as well as improved applicability and improved development residue. When the photosensitive resin composition of the present invention is used as a material for forming a planarization film, an interlayer dielectric, or the like of a semiconductor devise, an FPD, and so on, as its applicability is good, the FPD panel face with uniform lightness at the time of turning on a light of a panel can be produced. In addition, when the photosensitive resin composition of the present invention is used, no development residue can be formed. Therefore as no pattern opening defect problems would occur at a pattern opening part, the semiconductor devices, FPDs, etc. in which occurrences of wiring contact defect arising from the pattern opening defects are controlled can be produced. Consequently the photosensitive resin composition of the present invention can be particularly preferably applied for the materials of these applications wherein high heat resistance, high light transmittance are also required.

### Industrial Applicability

The photosensitive resin composition of the present invention can be used suitably as a material for forming an interlayer dielectric or a planarization film of a semiconductor, a FPD, and so on.

## Claims

1. A photosensitive resin composition comprising an alkali-soluble resin, a photosensitizer having a quinone diazide group and a solvent, wherein the alkali-soluble resin is an acrylic resin, the solvent is a mixture of propylene glycol monomethyl ether acetate and a solvent having smaller vapor pressure than that of propylene glycol monomethyl ether acetate under the normal temperature and the atmospheric pressure, and the photosensitive resin composition further comprises a phenolic compound represented by the general formula (I): 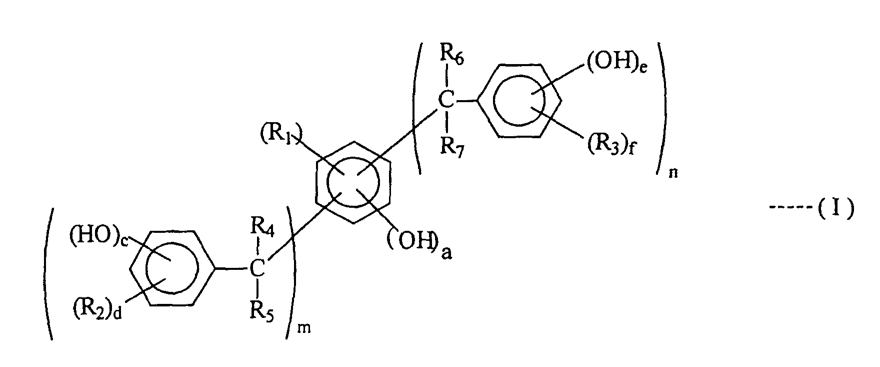 wherein R₁, R₂, R₃, R₄, R₅, R₆ and R₇ represent independently H, a C₁₋₄ alkyl group or 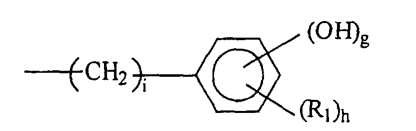 whereupon each of m and n is independently an integer of 0 to 2, each of a, b, c, d, e, f, g and h is an integer of 0 to 5 satisfying a + b ≤ 5, c + d ≤ 5, e + f ≤ 5 and g + h ≤ 5, and i is an integer of 0 to 2.

2. The photosensitive resin composition according to claim 1, wherein the solvent having smaller vapor pressure than that of propylene glycol monomethyl ether acetate under the normal temperature and the atmospheric pressure is at least one member selected from the group consisting of ethyl 2-hydroxpropionate, propylene glycol n-butyl ether and propylene glycol.

3. The photosensitive resin composition according to claim 2, wherein the mixing ratio of propylene glycol monomethyl ether acetate and a solvent that is at least one member selected from the group consisting of ethyl 2-hydroxpropionate, propylene glycol n-butyl ether and propylene glycol is from 95:5 to 50:50.

4. The photosensitive resin composition according to any one of claims 1 to 3, wherein the acrylic resin comprises a constitutional unit derived from an alkyl (meth) acrylate and a constitutional unit derived from (meth) acrylic acid.

5. The photosensitive resin composition according to claim 4, wherein the acrylic resin comprises a constitutional unit derived from (meth)acrylic acid by 5 to 30 mole-%.

6. The photosensitive resin composition according to any one of claims 1 to 5, wherein the photosensitizer having a quinone diazide group is a reaction product between the compound of the above general formula (I) and a naphthoquinone diazide compound.

7. The photosensitive resin composition according to claim 6, wherein the phenolic compound represented by the general formula (I) is a compound represented by the formula (II):

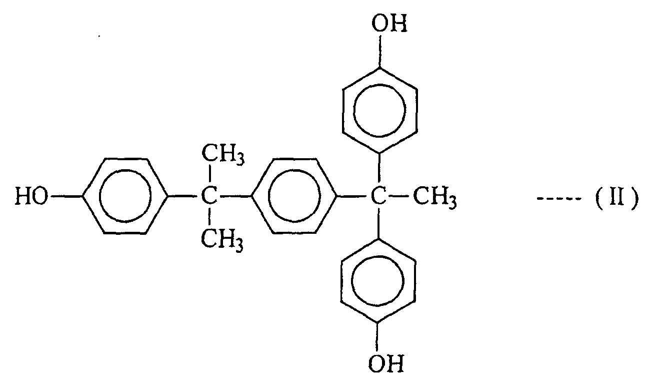

8. The photosensitive resin composition according to any one of claims 1 to 7, which further comprises a hardening agent having epoxy groups.

9. The photosensitive resin composition according to any one of claims 1 to 8, wherein the acrylic resin has the weight average molecular weight of 20,000 to 40,000 as determined by polystyrene standards.
